# EUROPEAN PATENT APPLICATION

(11) **EP 1 225 639 A1**
(43) Date of publication of application: **24.07.2002**
(21) Application number: 01830031.9
(22) Date of filing: 22.01.2001
(51) Int. Cl.: H01L 29/872

(54) **Silicon Schottky barrier diode**

(71) Applicant: STMicroelectronics S.r.l., 20041 Agrate Brianza MI (IT)
(72) Inventor: Saggio, Mario, 95021 Aci Castello (CT) (IT); Lanois, Frederic, 37100 Tours (FR); Frisina, Ferruccio, 95030 Sant'Agata li Battiati (CT) (IT)
(74) Representative: Mittler, Enrico

(57) **Abstract**

The present invention relates to a Schottky barrier diode comprising a substrate region (9) of a first conductivity type formed in a semiconductor material layer (10) of same conductivity type and a metal layer (12), characterized in that at least a doped region (13) of a second conductive type is formed in said semiconductor layer (10), each one of said doped regions (13) being disposed under said material layer (10) and being separated from other doped regions (13) by portions of said semiconductor layer (10).

## Description

The present invention relates to a silicon improved Schottky barrier diode, particularly to a Schottky barrier diode of high - voltage with a Multi Drain (MD) technology.

Schottky barrier diodes (generally indicated as SBD) are used as voltage rectifiers in many power switching applications. In fact whenever a current is switched to an inductive load, such as an electric motor, high - voltage transients on the conductive lines are induced.

Usually to suppress these transients, that is to rectify a waveform, a junction diode PN is used, and said diode PN is placed across each switching means, for example a power transistor, to clamp the voltage excursions.

PN junction diodes can be used for this application, but they store minority carriers when forward biased, and the extraction of these carriers generates a reverse current having a large transient during switching.

In switching applications, the PN diode is turned on and off by fast pulses, and the reverse recovery finite time limits the rate of pulses that can be applied, thus limiting the diode switching speed.

To overcome these drawbacks a metal - semiconductor rectifying junction, called MSJ, is used.

In this type of device, due to their internal physic phenomenon, the forward current consists of majority carriers injected from the semiconductor into the metal.

Consequently, MSJ do not store minority carriers when forward biased, and the reverse current transient is negligible. This means that the MSJ can be turned off faster than a PN diode, and therefore they dissipate a negligible power during switching.

However the on - resistance of the MSJ increases sharply with the growth of the voltage, and this occurrence limits their use to a voltage range of about 150 V - 200 V.

In ultra fast switching applications, over 200 V, mainly a bipolar diode is used. This diode is responsible for an important part of the dissipated power due mainly to the drain epitaxial layer resistance, and the dissipated power depends, also, on the doping concentration of the epitaxial layer itself.

In fact the power dissipation occurs in this type of diode during the conduction phase. If the working frequency increases, the power dissipation occurs more and more during the off - commutation not only in the diode but also in the parasite MOS, due to the diode charge recovery phenomenon.

In view of the state of the art described, it is an object of the present invention to provide a device able to suppress voltage transients, to work at high - voltage and to limit the power dissipation.

It is another object of the present invention to propose an alternative device respect to the bipolar diodes in ultra fast switching applications.

According to the present invention, such objects are achieved by Schottky barrier diode comprising a substrate region of a first conductivity type formed in a semiconductor material layer of same conductivity type and a metal layer, characterized in that at least a doped region of a second conductive type is formed in said semiconductor material layer, each one of said doped regions being disposed under said metal layer and being separated from other doped regions by portions of said semiconductor material layer.

Thanks to the present invention it is possible to make a Schottky barrier diode having an higher voltage breakdown.

Moreover, thanks to the present invention it is possible to make a Schottky barrier diode having a lower on - resistance with respect to the prior art.

The features and the advantages of the present invention will be made evident by the following detailed description of an embodiment thereof, which is illustrated as not limiting example in the annexed drawings, wherein:
Figure 1 shows a schematic cross sectional view of a Schottky barrier diode according to the prior art;
Figure 1A shows the relationship between the breakdown voltage and the on - resistance according to the prior art;
Figure 2 shows a first embodiment of a Multi Drain Schottky barrier diode according to the present invention;
Figure 3 shows a second embodiment of a Multi Drain Schottky barrier diode according to the present invention;
Figure 4A shows another schematic cross sectional view of the Schottky barrier diode according to the prior art;

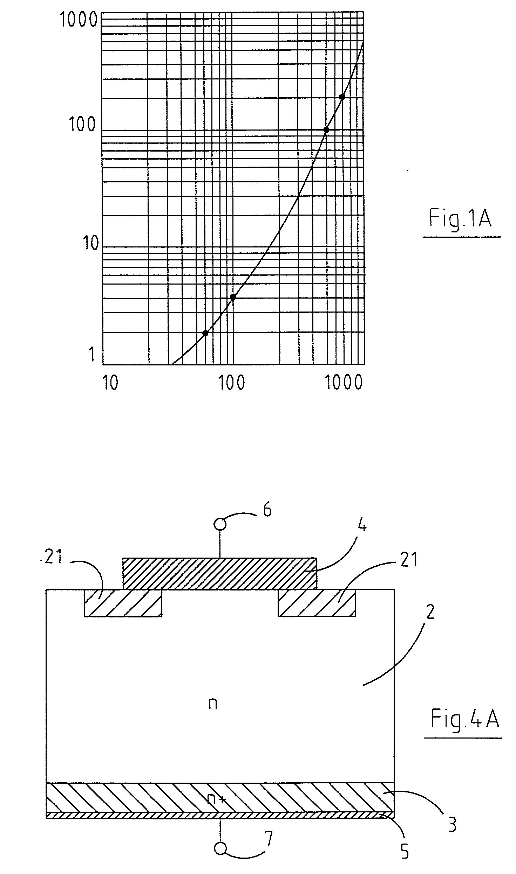

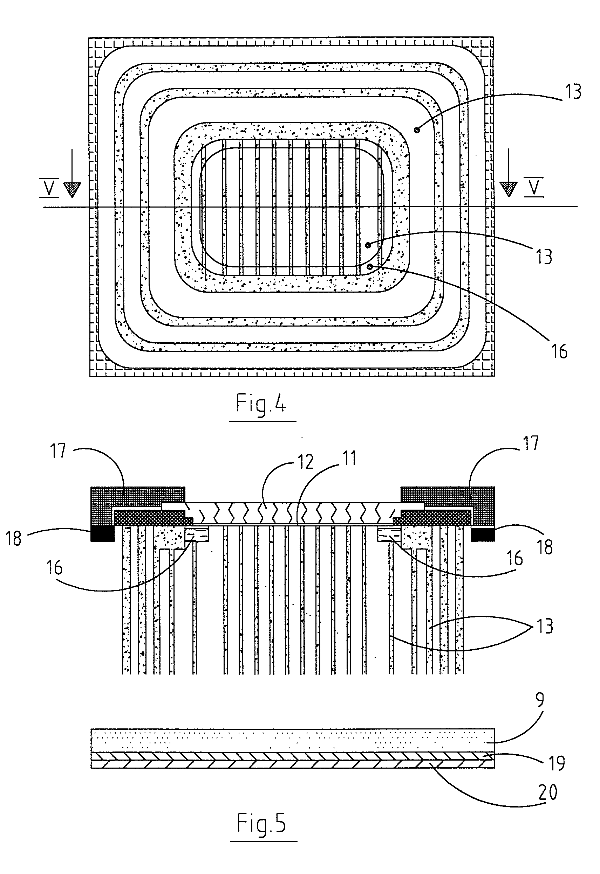

Figure 4 shows a top plan view of the first embodiment of Figure 2;
Figure 5 shows a cross sectional view of the first embodiment of Figure 2 along the line V - V.

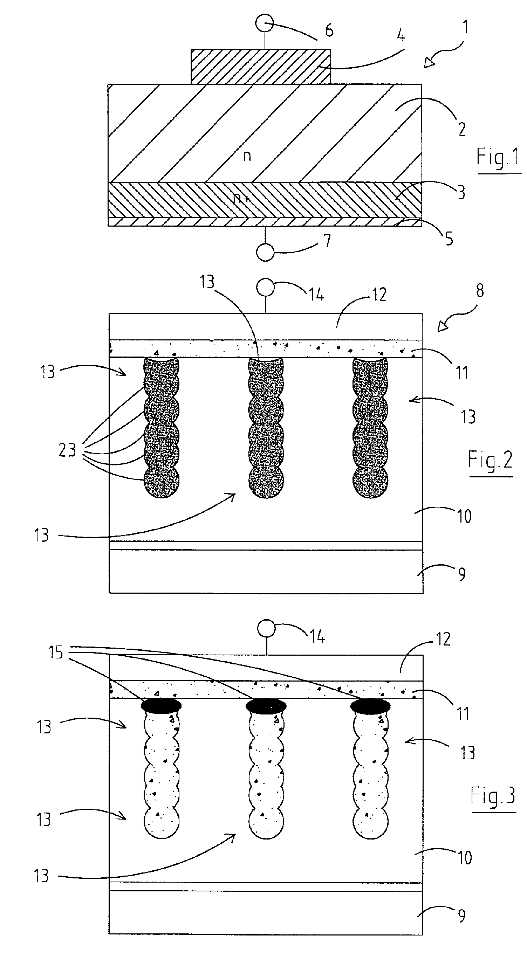

In Figure 1 a schematic cross sectional view of a Schottky barrier diode according to the prior art is shown. This device, indicated as 1, employs a n - type epitaxial layer 2 on n⁺ - type substrate 3, to reduce the diode series resistance.

The resistivity values and the thickness of a device adapted to sustain a voltage in a range between 100 V and 500 V, must be in a range of resistivity between 5 Ohm * cm and 20 Ohm * cm and in a range of thickness between 15 µm and 50 µm.

The diode 1 is fabricated by depositing a metal layer 4 of suitable size onto the n - type epitaxial layer 2, and by producing a metal - semiconductor contact 5, called ohmic contact. Said ohmic contact has a resistance negligibly small compared with the resistance of the n⁺ - type substrate 3 to which the ohmic contact itself is applied.

The metal layer 4 represents a first electrode 6, called anode, and the ohmic contact 5 represents a second electrode 7, called cathode.

The device 1 shows a leakage reverse large current and it has a low breakdown voltage because of the concentration of the electric field near the periphery of the device.

Moreover the on - resistance of the diode 1 increases sharply with the growth of the voltage, and this occurrence limits their use to a range of voltage between 150 V - 200 V.

In fact the law that links the voltage breakdown with the epitaxial layer resistivity is: BV ∝ ρ^{3/4}
where BV is the breakdown voltage and p is the epitaxial layer resistivity.

Such a formula is shown in the graph of Figure 1A, wherein there is an abscissa axis illustrating the breakdown voltage expressed in V and an ordinate axis illustrating the on - resistance of the active area expressed in mOhm * cm².

To overcome these problems the Applicant has found that to obtain a Schottky barrier diode with a low on - resistance and a high breakdown voltage it is necessary to produce devices with drain layers comprising a Multi Drain structures, as shown in Figure 2.

In this way the Applicant has realized a device having an higher voltage capability for a given epitaxy doping level, an higher voltage breakdown and a lower on - resistance with respect to the known devices.

In Figure 2 a cross sectional view of a first embodiment of a Multi Drain Schottky barrier diode according to the present invention is shown.

As shown in such Figure the new device 8 comprises a substrate 9 heavily doped, onto which a semiconductor layer 10 is formed, for example by an epitaxial growth. In specific embodiment either the substrate 9 and the semiconductor layer 10 are of n type conductivity.

In the substrate 9 an ohmic contact (not shown in Figure) is formed by creating a thin, heavily doped semiconductor region of the same conductivity type placed between the metal (not shown in Figure) and the same substrate 9.

Over the surface of the semiconductor layer 10, also called epitaxial layer, a thin silicide layer 11 is formed, for example by a thermal growth, made by, for example, PtNi.

This silicide layer 11 defines the electrical characteristics of the Schottky Barrier diode.

At the top of the device 8 there is, for example, a metal layer 12, deposited for all the length of the device 8. This metal layer 12 is made by aluminum and it acts as an electrode 14, called anode.

The epitaxial layer 10 makes a common drain layer for the device 8 and, inside said epitaxial layer 10, it makes also a plurality of regions 13, also called columns, of an opposite conductivity type.

In fact the p type columns 13 are opportunely doped to balance the charge on the n type zone 10. When this condition is reached, the electric field upon the entire volume of the drain region is constant and it is also equal to the critical electric field of the silicon.

This embodiment allows to sustain a high voltage also in presence of a little resistivity of the n type zone 10.

As a result of the presence of the regions or columns 13, it is possible, therefore, to reduce the resistivity of the epitaxial layer 10 without decreasing the breakdown voltage of the Schottky barrier diode 8, because the breakdown voltage depends on the resistivity and on the thickness of the portions of the common drain layer beneath the metal layer 12.

Substantially the presence of the doped regions 13 under the metal layer 12 allows achievement of the desired breakdown voltage and capability of current transportation even with an epitaxial layer having a lower resistivity than that necessary respect with the conventional Schottky barrier diodes.

To form the doped regions 13 a p - type dopant, such as boron, is implanted.

In fact during the growth of the epitaxial layer 10, that involves a thermal process, the p type dopant diffuses vertically into the epitaxial layer 10 to form a plurality of bubbles 23, so to realize the p type columns 13.

In fact the innovative Multi Drain process provides that the p type columns 13 are made by a sequence of successive growths of the n type epitaxial layer 10 and by a p type dopant implants. This is possible by means of suitable masks that localize the p type bubbles 23 in the n type epitaxial layer 10.

A successive thermal process modifies the p type bubble sequences into the p type column 13.

The dopant concentration of the p type columns 13, together with their geometrical disposition and size, is suitable to sustain the desired high voltage.

The dose of these implants ranges, for example, from 1 x 10¹² to 5 x 10¹³ at / cm⁻².

As a consequence of the decreased resistivity of the epitaxial layer 10, the on - resistance of the device 8 is reduced, so to the current flux coming from the anode electrode and flowing towards the substrate 9 encounters a lower resistance.

However, while in conventional Schottky barrier diode the resistivity of the epitaxial layer 10 is determined on the basis of the desired breakdown voltage, in the present invention the epitaxial layer 10 has a resistivity which is lower than the necessary to achieve the same desired breakdown voltage.

For example in a device working at 500 V, implemented with traditional technology, a resistivity of about 20 Ohm * cm is to be used, while with the present invention the resistivity can be less than 5 Ohm * cm.

Therefore the Multi Drain structure of the present invention allows to reach higher value of breakdown voltage.

Moreover to improve the value of the breakdown voltage it is necessary to increase the height of the p type columns 13.

Referring to Figure 2, the semiconductor layer 10 is epitaxially grown over the heavily doped substrate 9, and the thickness of the epitaxial layer 10 depends on the voltage class for which the device is provided for.

In this specific embodiment for a Schottky barrier diode operating at about 600 V, the thickness of the metal layer 12 is about few µm, the epitaxial layer 10 can have a thickness more than 40 µm and a value of doping of about 9 x 10¹⁴ cm⁻³ and the substrate 9 can have a value of doping of about 2 x 10¹⁹ cm⁻³.

In Figure 3 a second embodiment of a Multi Drain Schottky barrier diode according to the present invention is shown.

As shown in such Figure, a part of the elements already described in Figure 2, a plurality of body regions 15, made by the opposite conductivity type of the drain layer, is shown.

In the specific embodiment, the drain layer or epitaxial layers 10 are made by n - type semiconductor and therefore the plurality of columns 13 is made p - type semiconductor and the body regions 15 are made by heavily doped p - type semiconductor, that is p +.

Said p + type body regions 15, placed at the top of each p - type column 13, reduce the electric field at the surface and by this way, they reduce the leakage current.

The p + type body regions 15 act as a ring guard of the force lines of the electric field and therefore they do not develop any function of contact between the drain layer and the anode electrode.

In Figure 4A a schematic cross sectional view of the Schottky barrier diode is shown.

In such a Figure it is to be noted a device 22 that is the prior art of the embodiments illustrated successively in Figures 4 and 5.

It is to be noted, also, comparing Figure 4A to Figure 1, that there is a couple 21 of p type wells on the board of the metal layer 4. This metal layer 4 defines the device and limits the leakage current.

In Figure 4 and 5 a top plan view of the first embodiment of Figure 2 and a cross sectional view of the same embodiment of Figure 2 along the line V - V are shown.

Particularly in the top plan view of Figure 4 a single Schottky barrier diode with the Multi Drain structure is shown.

The Multi Drain structure comprises a plurality of p type columns 13 and a p + type ring guard 16. It is also shown an n + type channel stop 17, to prevent the leakage current.

Particularly in the cross sectional view of Figure 5 an oxide passivation layer 18, such as probimide, and the n + channel stop 17 are shown. It is also shown a silicide layer 19, made, for example, of Pt, that allows to realize a device with a lower resistance. Moreover this silicide layer 19 is combined with a metal layer 20, made, for example, of TiNiAu, that acts as a finish of the wafer slice to improve the current flux.

It is to be noted, as shown in Figures 4 and 5, that the horizontal layout of the device, according to the present invention, is a structure that grows substantially vertically with a well defined number of p type columns, starting from a stripe layout closed around by a sequence of rings of type p. These p type rings of the board extend also vertically as a column shape.

## Claims

1. Schottky barrier diode comprising a substrate region (9) of a first conductivity type formed in a semiconductor material layer (10) of same conductivity type and a metal layer (12), **characterized in that** at least a doped region (13) of a second conductive type is formed in said semiconductor material layer (10), each one of said doped regions (13) being disposed under said metal layer (12) and being separated from other doped regions (13) by portions of said semiconductor layer (10).

2. Schottky barrier diode according to claim 1, **characterized in that** said semiconductor material layer (10) has a first resistivity value, and said doped regions (13) have a second resistivity value higher than said first resistivity value.

3. Schottky barrier diode according to claim 1, **characterized in that** said substrate (9) has doping value higher than the doping value of said semiconductor material layer (10).

4. Schottky barrier diode according to claim 1, **characterized in that** said doped regions (13) have respective body regions (15).

5. Schottky barrier diode according to claim 1, **characterized in that** said doped regions (13) are doped in such a manner to equalize the charge in said semiconductor material layer (10).

6. Schottky barrier diode according to claim 1, **characterized in that** said body regions (15) are heavily doped with the same conductivity type of said doped regions (13).

7. Schottky barrier diode according to anyone of previous claims, **characterized in that** a value of resistivity of said semiconductor material layer (10) is lower than 5 Ohm x cm for a breakdown voltage (BV) higher than 200V.

8. Schottky barrier diode according to anyone of previous claims, **characterized in that** said doped regions (13) are doped with p type dopant.

9. Schottky barrier diode according to anyone of previous claims, **characterized in that** said semiconductor material layer (10) is doped with n type dopant.
